# EUROPEAN PATENT APPLICATION

(11) **EP 4 068 358 A2**
(43) Date of publication of application: **05.10.2022**
(21) Application number: 22161768.1
(22) Date of filing: 14.03.2022
(51) Int. Cl.: H01L 27/02, H01L 27/118

(54) **SEMICONDUCTOR INTEGRATED CIRCUIT**

(30) Priority: 30.03.2021 US 202117217281
(71) Applicant: Renesas Electronics Corporation, Tokyo 135-0061 (JP)
(72) Inventor: YADOGUCHI, Yasuhiro, Tokyo, 135-0061 (JP)
(74) Representative: Betten & Resch

(57) **Abstract**

A semiconductor integrated circuit includes a first semiconductor layer, a second semiconductor layer, and a first cell and a second cell which are arranged adjacent to each other along a first direction. Each of the first cell and the second cell has a polygonal boundary shape with n (where, n is a natural number of >4) sides. The first cell includes a plurality of first MOS transistors and a plurality of second MOS transistors. The second cell includes a plurality of third MOS transistors and a plurality of fourth MOS transistors. The first cell and the second cell are arranged such that each of the first cell and the second cell has a region overlapping with each other in a second direction.

## Description

### BACKGROUND

The present disclosure relates to a semiconductor integrated circuit including standard cells.

In cell-based semiconductor integrated circuits, desired functions have been realized by arranging multiple types of standard cells constituting logic circuits and connecting them.

There is a disclosed technique listed below.
[Patent Document 1] Japanese Unexamined Patent Application Publication No. 2004-362420
Patent Document 1 discloses a technique in which a cell sorting means arranges a plurality of standard cells.

### SUMMARY

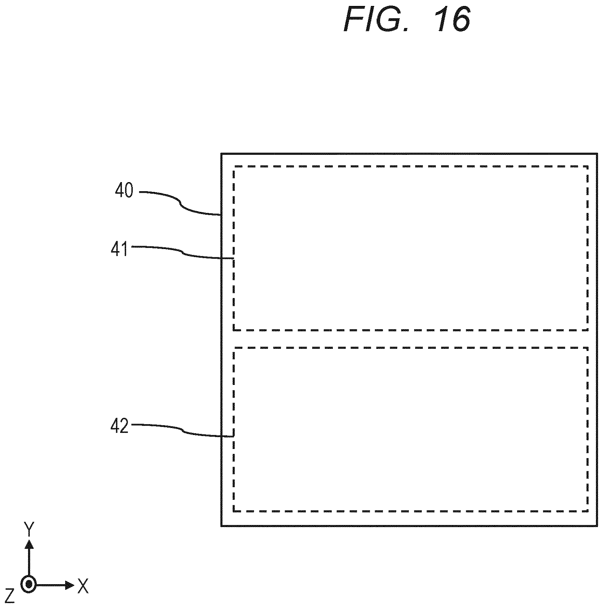

A logic circuit in a standard cell is configured by a P-channel Metal-Oxide-Semiconductor (MOS) transistor and an N-channel MOS transistor. Therefore, the standard cell includes a region where the P-channel MOS transistor is formed and a region where the N-channel MOS transistor is formed. FIG. 16 is a plan view showing a typical layout of a standard cell. As shown in FIG. 16, a standard cell 40 includes a P-channel MOS transistor forming region 41 and an N-channel MOS transistor forming region 42. The P-channel MOS transistor forming region 41 and the N-channel MOS transistor forming region 42 are arranged adjacent to each other in the Y axis direction.

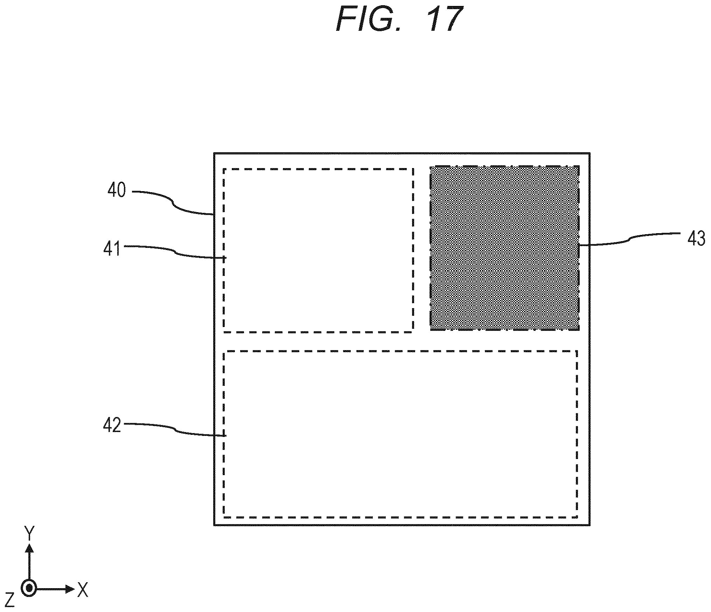

Incidentally, in semiconductor integrated circuits, the number of P-channel MOS transistors and the number of N-channel MOS transistors included in a standard cell is adjusted to obtain desired circuit characteristics. For example, if adjustment is made to reduce the number of P-channel MOS transistors with respect to the number of N-channel MOS transistors, the P-channel MOS transistor forming region 41 becomes smaller than the N-channel MOS transistor forming region 42 (see FIG. 17).

However, as described in Patent Document 1, the standard cell 40 has a quadrangular boundary shape. Therefore, as shown in FIG. 17, a region 43 where the transistor is not formed, that is, a dead space is generated in the standard cell 40. Namely, there is a problem that leads to a decrease in the degree of integration of the transistor elements in the semiconductor integrated circuit.

Other objects and new features will be apparent from the description of this specification and the accompanying drawings.

A semiconductor integrated circuit according to one embodiment includes a first semiconductor layer which has a first conductivity type, a second semiconductor layer which has a second conductivity type, and a first cell and a second cell which are arranged adjacent to each other along a first direction. Each of the first cell and the second cell has a polygonal boundary shape with n (where, n is a natural number of >4) sides. The first cell includes a plurality of first MOS transistors which are formed on the second semiconductor layer and which have the first conductivity type, and a plurality of second MOS transistors which are formed on the second semiconductor layer and which has the second conductivity type. The second cell includes a plurality of third MOS transistors which are formed on the second semiconductor layer and which have the first conductivity type, and a plurality of fourth MOS transistors which are formed on the second semiconductor layer and which has the second conductivity type. The first cell and the second cell are arranged such that each of the first cell and the second cell has a region overlapping with each other in a second direction different from the first direction.

According to one embodiment, since the standard cell which does not include a dead space can be efficiently arrange on the semiconductor integrated circuit, it is possible to reduce the area of the semiconductor chip and improve the integration rate of the transistor elements.

### BRIEF DESCRIPTION OF THE DRAWINGS

FIG. 1 is a plan view showing an example of a layout of a semiconductor integrated circuit according to a first embodiment.
FIG. 2 is a plan view showing an example of a layout of a semiconductor integrated circuit as a comparative example.
FIG. 3 is a plan view showing an example of a layout of a semiconductor integrated circuit according to the first embodiment.
FIG. 4 is a flowchart showing an example of a design flow of a semiconductor integrated circuit according to the first embodiment.
FIG. 5 is a plan view explaining an example of a method of arranging adjustment cells according to the first embodiment.
IG. 6 is a plan view explaining the example of the method arranging the adjustment cells according to the first embodiment.
FIG. 7 is a plan view explaining the example of the method arranging the adjustment cells according to the first embodiment.
FIG. 8 is a plan view explaining the example of the method arranging the adjustment cells according to the first embodiment.
FIG. 9 is a plan view showing an example of a layout of a semiconductor integrated circuit according to the first embodiment.
FIG. 10 is a plan view showing an example of a layout of an adjustment cell according to the first embodiment.
FIG. 11 is a plan view showing an example of a layout of a semiconductor integrated circuit according to a second embodiment.
FIG. 12 is a plan view showing an example of a layout of a standard cell according to the second embodiment.
FIG. 13 is a plan view showing an example of a layout of a standard cell according to the second embodiment.
FIG. 14 is a plan view showing an example of a layout of a standard cell according to the second embodiment.
FIG. 15 is a plan view showing an example of a layout of a semiconductor integrated circuit according to the second embodiment.
FIG. 16 is a plan view showing a typical layout of a standard cell.
FIG. 17 is a plan view showing a typical layout of a standard cell.

### DETAILED DESCRIPTION

Hereinafter, embodiments will be described in detail with reference to the drawings. In the specification and the drawings, the same or corresponding components are denoted by the same reference numerals, and a repetitive description thereof is omitted. In the drawings, for convenience of description, the configuration may be omitted or simplified.

For convenience of description, an XYZ orthogonal coordinate axis system is introduced. One direction (a first direction) and another direction (a second direction different from the first direction) orthogonal to each other in a plane parallel to the drawing are defined as an X axis direction and a Y axis direction. The direction orthogonal to the drawing is defined as a Z axis direction.

### First Embodiment

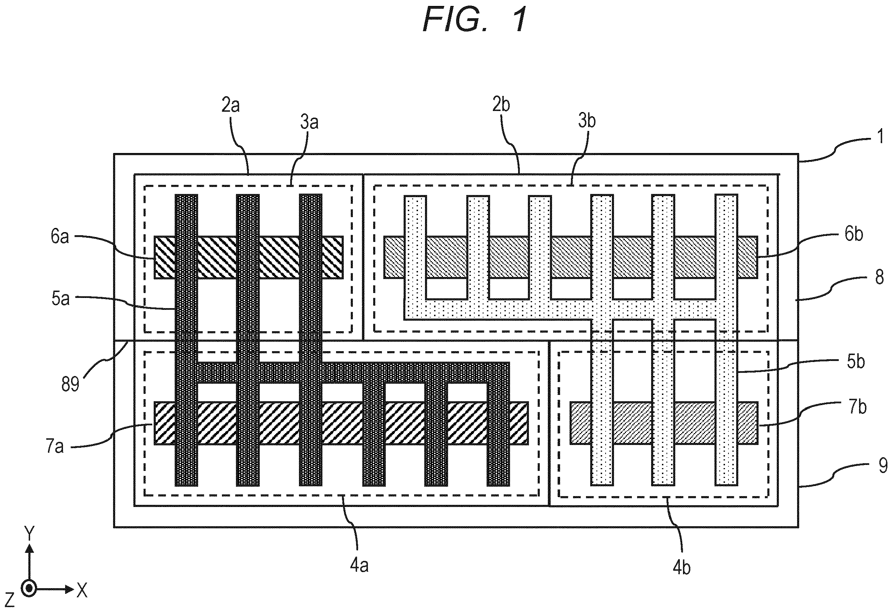

FIG. 1 is a plan view showing an example of a layout of a semiconductor integrated circuit 1 according to a first embodiment. In FIG. 1, only a part of the semiconductor integrated circuit 1 is shown. As shown in FIG. 1, adjustment cells 2a and 2b are arranged adjacent to each other the X axis direction on the semiconductor integrated circuit 1. Further, in the Z axis direction, that is, in the plan view of the semiconductor integrated circuit 1, the boundary shape of the adjustment cell 2a is an L-shaped hexagon with six sides. The boundary shape of the adjustment cell 2b is an inverted L-shaped hexagon with six sides. Thus, the boundary shapes of the adjustment cells 2a and 2b according to the first embodiment are not quadrangular.

The adjustment cell 2a with the L-shaped boundary shape and the adjustment cell 2b with the inverted L-shaped boundary shape are in a congruent figure relationship. As shown in FIG. 1, the adjustment cells 2a and 2b are arranged adjacent to each other such that the projection part and the recess part of the boundary shape of the adjustment cell 2a and the projection part and the recess part of the boundary shape of the adjustment cell 2b are in contact without a gap. In other words, the adjustment cell 2a having the L-shaped boundary shape and the adjustment cell 2b having the inverted L-shaped boundary shape are arranged adjacent to each other along the X axis direction and are arranged such that each of the adjustment cells 2a and 2b has a region overlapping with each other in the Y axis direction. As a result, a large quadrangle is formed as a whole of the adjustment cells 2a and 2b.

The adjustment cells 2a and 2b are Complementary MOS (CMOS) inverters constituting basic logic cells. A basic logic cell is a type of cell included in a standard cell. Each of the adjustment cells 2a and 2b has a CMOS circuit including P-channel MOS transistors and N-channel MOS transistors whose inputs are common. Incidentally, there are intra-cell wiring sharing the power supply and intra-cell wiring constituting the output in each of the adjustment cells 2a and 2b constituting the CMOS inverters, but they are omitted here.

Also, as a result of the number of MOS transistors is adjusted to obtain the desired circuit characteristics, the number of P-channel MOS transistors and the number of N-channel MOS transistors included in each of the adjustment cells 2a and 2b are different. In this specification, a standard cell in which the number of P-channel MOS transistors and the number of N-channel MOS transistors are different is also referred to as an adjustment cell.

The adjustment cell 2a includes a P-channel MOS transistor forming region 3a and an N-channel MOS transistor forming region 4a. The adjustment cell 2b includes a P-channel MOS transistor forming region 3b and an N-channel MOS transistor forming region 4b. The P-channel MOS transistor forming regions 3a and 3b are formed by an N-type well 8 (second semiconductor layer). The N-type well 8 is formed in the surface layer of the semiconductor integrated circuit 1 by doping with an N-type impurity. The N-channel MOS transistor forming regions 4a and 4b are formed by a P-type well 9 (first semiconductor layer). The P-type well 9 is formed in the surface layer of the semiconductor integrated circuit 1 by doping with a P-type impurity. The N-type well 8 and the P-type well 9 are arranged adjacent to each other in the Y axis direction. The N-type well 8 is arranged in the +Y axis direction. The P-type well 9 is arranged in the -Y axis direction.

A common gate electrode 5a is arranged in the P-channel MOS transistor forming region 3a and the N-channel MOS transistor forming region 4a. The gate electrode 5a is formed above the N-type well 8 in the P-channel MOS transistor forming region 3a and the P-type well 9 in the N-channel MOS transistor forming region 4a via an insulating film (not shown). For example, the gate electrode 5a is formed by a polysilicon layer.

A common gate electrode 5b is arranged in the P-channel MOS transistor forming region 3b and the N-channel MOS transistor forming region 4b. The gate electrode 5b is formed above the N-type well 8 in the P-channel MOS transistor forming region 3b and the P-type well 9 in the N-channel MOS transistor forming region 4b via an insulating film (not shown). For example, the gate electrode 5b is formed by a polysilicon layer.

P+ diffusion layers 6a and 6b are arranged in each of the P-channel MOS transistor forming regions 3a and 3b. Specifically, in the plan view of the semiconductor integrated circuit 1, a plurality of P+ diffusion layers 6a is arranged on both sides of the gate electrode 5a in the P-channel MOS transistor forming region 3a. In other words, the P+ diffusion layer 6a is arranged to sandwich a region of the N-type well 8 covered by the gate electrode 5a. Further, in the plan view of the semiconductor integrated circuit 1, a plurality of P+ diffusion layers 6a is arranged on both sides of the gate electrode 5b in the P-channel MOS transistor forming region 3b. In other words, the P+ diffusion layer 6b is arranged to sandwich a region of the N-type well 8 covered by the gate electrode 5b. The P+ diffusion layers 6a and 6b are formed in the surface layer of the N-type well 8 by doping with a P-type impurity. The P-type impurity concentration of each of the P+ diffusion layers 6a and 6b is set to be larger than the P-type impurity concentration of the P-type well 9.

The P+ diffusion layers 6a and 6b constitute sources and drains of the P-channel MOS transistors. A power supply wiring (not shown) is connected to the P+ diffusion layers 6a and 6b serving as the sources of the P-channel MOS transistors. The surface layers of the N-type well 8 covered by the gate electrodes 5a and 5b function as the channel layers of the P-channel MOS transistors. In the P-channel MOS transistor forming region 3a of FIG. 1, since the three gate electrodes 5a extending in the Y axis direction are arranged, three P-channel MOS transistors are formed. Further, in the P-channel MOS transistor forming region 3b of FIG. 1, since the six gate electrodes 5b extending in the Y axis direction are arranged, six P-channel MOS transistors are formed.

N+ diffusion layers 7a and 7b are arranged in each of the N-channel MOS transistor forming regions 4a and 4b. Specifically, in the plan view of the semiconductor integrated circuit 1, a plurality of N+ diffusion layer 7a is arranged on both sides of the gate electrode 5a in the N-channel MOS transistor forming region 4a. In other words, the N+ diffusion layer 7a is arranged to sandwich a region of the P-type well 9 covered by the gate electrode 5a. Further, in the plan view of the semiconductor integrated circuit 1, a plurality of N+ diffusion layers 7b is arranged on both sides of the gate electrode 5b of the N-channel MOS transistor forming region 4b. In other words, the N+ diffusion layer 7b is arranged to sandwich a region of the P-type well 9 covered by the gate electrode 5b. The N+ diffusion layers 7a and 7b are formed in the surface layer of the P-type well 9 by doping with an N-type impurity. The N-type impurity concentration of each of the N+ diffusion layers 7a and 7b is set to be larger than the N-type impurity concentration of the N-type well 8.

The N+ diffusion layers 7a and 7b constitute sources and drains of the N-channel MOS transistors. A power supply wiring (not shown) is connected to the N+ diffusion layers 7a and 7b serving as the sources of the N-channel MOS transistors. The surface layers of the P-type well 9 covered by the gate electrodes 5a and 5b function as the channel layers of the N-channel MOS transistor. In the N-channel MOS transistor forming region 4a of FIG. 1, since the six gate electrodes 5a extending in the Y axis direction are arranged, six N-channel MOS transistors are formed. Further, in the N-channel MOS transistor forming region 4b of FIG. 1, since the three gate electrodes 5b extending in the Y axis direction are arranged, three N-channel MOS transistors are formed.

The adjustment cell 2a includes the three P-channel MOS transistors in the P-channel MOS transistor forming region 3a and the six N-channel MOS transistors in the N-channel MOS transistor forming region 4a. The inputs of the three P-channel MOS transistors and the six N-channel MOS transistors in the adjustment cell 2a are commonly connected by the gate electrode 5a.

The adjustment cell 2a has a layout of a CMOS circuit in which the three P-channel MOS transistors formed in the P-channel MOS transistor forming region 3a and the six N-channel MOS transistors formed in the N-channel MOS transistor forming region 4a are arranged adjacent to each other in the Y axis direction. Since the number of P-channel MOS transistors included in the adjustment cell 2a differs from the number of N-channel MOS transistors included in the adjustment cell 2a, the shape of the CMOS circuit is asymmetric with respect to the border 89 between the N-type well 8 and the P-type well 9. Then, the adjustment cell 2a has an L-shaped hexagonal boundary shape along the shape of the layout of the asymmetric CMOS circuit.

Specifically, the difference between the number of P-channel MOS transistors and the number of N-channel MOS transistors is 3. That is, the size of the P-channel MOS transistor forming region 3a and the size of the N-channel MOS transistor forming region 4a differ depending on the presence or absence of a region for forming the three MOS transistors. In FIG. 1, the P-channel MOS transistor forming region 3a is shorter in the +X axis direction than the N-channel MOS transistor region 4a and has a recessed shape (recess part). Further, in FIG. 1, the N-channel MOS transistor forming region 4a is longer in the +X axis direction than the P-channel MOS transistor region 3a and has a projecting shape (projection part). The boundary shape of the adjustment cell 2a is an L-shaped hexagon along the shape of the layout of the CMOS circuit having the projection part and the recess part generated by the differences between the number of P-channel MOS transistors and the number of N-channel MOS transistors.

Further, the adjustment cell 2b includes the six P-channel MOS transistors in the P-channel MOS transistor forming region 3b and the three N-channel MOS transistors in the N-channel MOS transistor forming region 4b. The inputs of the six P-channel MOS transistors and the three N-channel MOS transistors in the adjustment cell 2b are commonly connected by the gate electrode 5b.

The adjustment cell 2b has a layout of a CMOS circuit in which the six P-channel MOS transistors formed in the P-channel MOS transistor forming region 3b and the three N-channel MOS transistors formed in the N-channel MOS transistor forming region 4b are arranged adjacent to each other in the Y axis direction. Since the number of P-channel MOS transistors included in the adjustment cell 2b differs from the number of N-channel MOS transistors included in the adjustment cell 2b, the shape of the layout of the CMOS circuit is asymmetric with respect to the border 89 between the N-type well 8 and the P-type well 9. Then, the adjustment cell 2b has an inverted L-shaped hexagonal boundary shape along the shape of the layout of the asymmetric CMOS circuit.

Specifically, the difference between the number of P-channel MOS transistors and the number of N-channel MOS transistors is 3. That is, the size of the P-channel MOS transistor forming region 3b and the size of the N-channel MOS transistor forming region 4b differ depending on the presence or absence of a region for forming the three MOS transistors. In FIG. 1, the P-channel MOS transistor forming region 3b is longer in the -X axis direction than the N-channel MOS transistor region 4b and has a projecting shape (projection part). Further, in FIG. 1, the N-channel MOS transistor forming region 4b is shorter in the -X axis direction than the P-channel MOS transistor region 3b, and a recessed shape (recess part). The boundary shape of the adjustment cell 2b is an inverted L-shaped hexagon along the shape of the layout of the CMOS circuit having the projection part and the recess part generated by the difference between the number of P-channel MOS transistors and the number of N-channel MOS transistors.

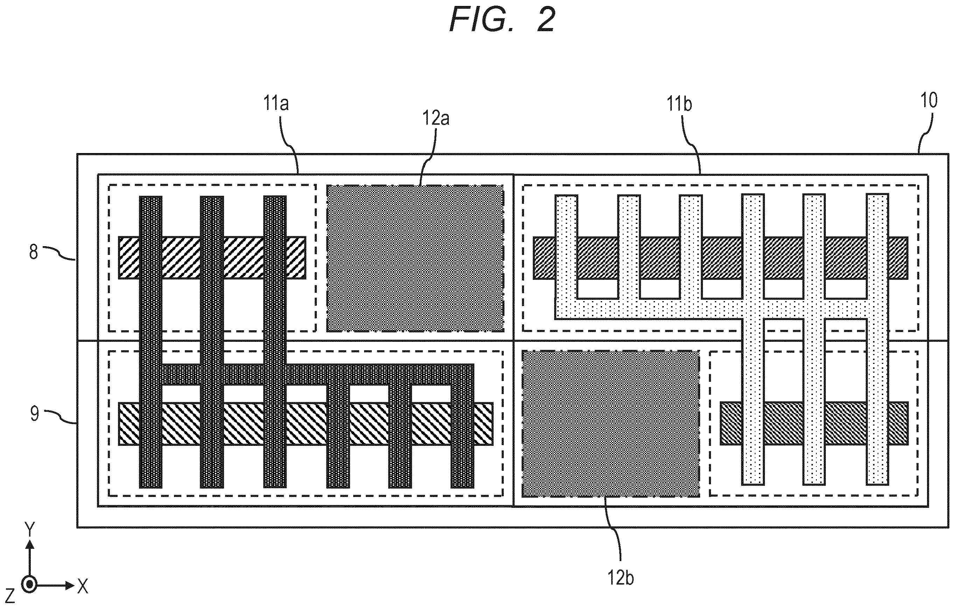

FIG. 2 is a plan view showing an example of a layout of a semiconductor integrated circuit 10 when the boundary shapes of the adjustment cells 2a and 2b of FIG. 1 are quadrangular. The semiconductor integrated circuit 10 of FIG. 2 is a comparative example of the semiconductor integrated circuit 1 of FIG. 1. As shown in FIG. 2, the adjustment cells 11a and 11b are arranged on the semiconductor integrated circuit 10. The boundary shapes of the adjustment cells 11a and 11b are quadrangular. The adjustment cells 11a and 11b are arranged adjacent to each other in the X axis direction.

Each of the adjustment cells 11a and 11b is a basic logic cell constituting a CMOS inverter. Since the number of P-channel MOS transistors and the number of N-channel MOS transistors included in the adjustment cell 11a are the same as those of the adjustment cell 2a, the adjustment cell 11a has the same layout of the CMOS circuit as the adjustment cell 2a. Further, since the number of P-channel MOS transistors and the number of N-channel MOS transistors included in the adjustment cell 11b are the same as those of the adjustment cell 2b, the adjustment cell 11b has the same layout of the CMOS circuit as the adjustment cell 2b. However, as described above, since the boundary shapes of the adjustment cells 11a and 11b are quadrangular, the adjustment cells 11a and 11b include a dead space that is a region where a transistor is not formed.

As shown in FIG. 2, the adjustment cell 11a includes a dead space 12a on the region side of the N-type well 8. The dead space 12a is a region generated because the number of P-channel MOS transistors is three less than the number of N-channel MOS transistors, in the adjustment cell 11a having the quadrangular boundary shape. Since the dead space 12a is a region where MOS transistor is not formed, it becomes a factor of increasing the chip area of the semiconductor integrated circuit 10 and also a factor of lowering the integration rate of the transistor elements of the semiconductor integrated circuit 10.

Further, as shown in FIG. 2, the adjustment cell 11b includes a dead space 12b on the region side of the P-type well 9. The dead space 12b is a region generated because the number of N-channel MOS transistors is three less than the number of P-channel MOS transistors, in the adjustment cell 11b having the quadrangular boundary shape. Since the dead space 12b is a region where MOS transistor is not formed, similarly to the dead space 12a, it becomes a factor of increasing the chip area of the semiconductor integrated circuit 10 and also a factor of lowering the integration rate of the transistor elements of the semiconductor integrated circuit 10.

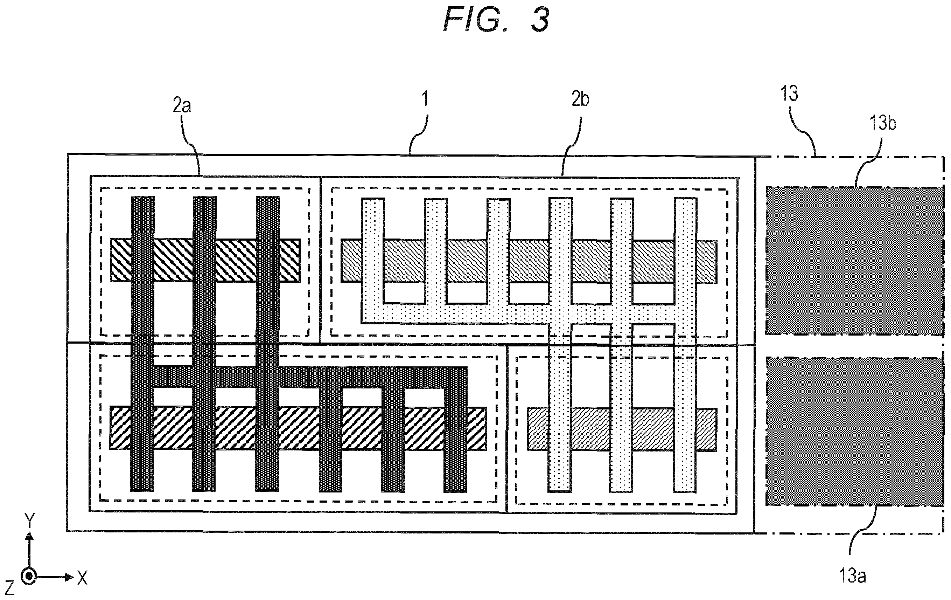

In contrast, the boundary shapes of the adjustment cells 2a and 2b according to the first embodiment are the L-shaped and inverted L-shaped hexagons along the shape of the layout of the asymmetric CMOS circuit. Therefore, the adjustment cells 2a and 2b have no dead space. FIG. 3 is a plan view showing an example of a layout of the semiconductor integrated circuit 1 that does not include a dead space. As shown in FIG. 3, the adjustment cell 2a having the L-shaped boundary shape and the adjustment cell 2b having the inverted L-shaped boundary shape are arranged in combination on the semiconductor integrated circuit 1. In other words, on the semiconductor integrated circuit 1, the adjustment cells 2a and 2b are arranged adjacent to each other so as to fill the portions corresponding to the dead spaces 12a and 12b of FIG. 2.

A region 13 of FIG. 3 shows an area of the semiconductor integrated circuit 1 that can be reduced with respect to the semiconductor integrated circuit 10 of FIG. 2. Further, regions 13a and 13b included in the region 13 have the same areas as the dead spaces 12a and 12b of FIG. 2, respectively. Thus, as compared with the semiconductor integrated circuit 10 in which the adjustment cells 11a and 11b having the quadrangular boundary shape are arranged, the semiconductor integrated circuit 1 in which the adjustment cells 2a and 2b according to the first embodiment are arranged can reduce the size of the semiconductor chip and improve the integration rate of the transistor elements.

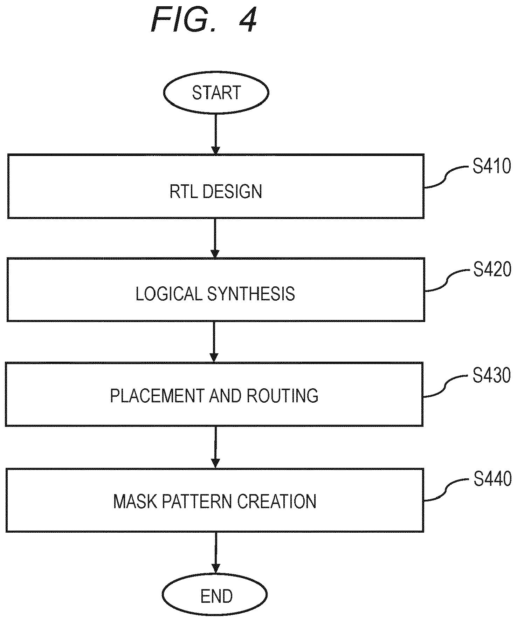

Next, a design flow of a semiconductor integrated circuit using an adjustment cell according to the first embodiment will be described. FIG. 4 is a flowchart showing an example of a design flow of a semiconductor integrated circuit using an adjustment cell according to the first embodiment. The flowchart of FIG. 4 includes four processing steps S410 to S440. First, in the step S410, a Register Transfer Level (RTL) design is performed. In the RTL design, an RTL is created based on a design specification for a semiconductor integrated circuit. The RTL is described using a hardware description language.

In the step S420, logical synthesis is performed. The logic synthesis is performed using a logic synthesis tool. The logic synthesis tool compiles the source file of the RTL described by the hardware description language and generates a netlist description of logic gates and transistors using a cell library.

The cell library is a collection of multiple types of standard cells. The standard cells included in the cell library include basic logic cells that constitute basic logic circuits such as an inverter, an AND circuit, a flip-flop, and the like. The basic logic cells include, in addition to cells having a conventional quadrangular boundary shape, adjustment cells having L-shaped and inverted L-shaped boundary shapes according to the first embodiment. The cell library stores information such as logical functions, electrical characteristics and layouts of standard cells.

In the step S430, processing of placement and routing is performed. The processing of the placement and routing is performed using a placement and routing tool. The placement and routing tool arranges standard cells on the semiconductor chip and connects the arranged standard cells with wiring, using the netlist generated in the step S420 and the cell library. As described above, the cell library includes adjustment cells having L-shaped and inverted L-shaped boundary shapes according to the first embodiment, and the adjustment cells having the L-shaped and inverted L-shaped boundary shapes according to the first embodiment are arranged on the semiconductor integrated circuit. The placement and routing tool generates a netlist and placement information as a result of the processing of the placement and routing.

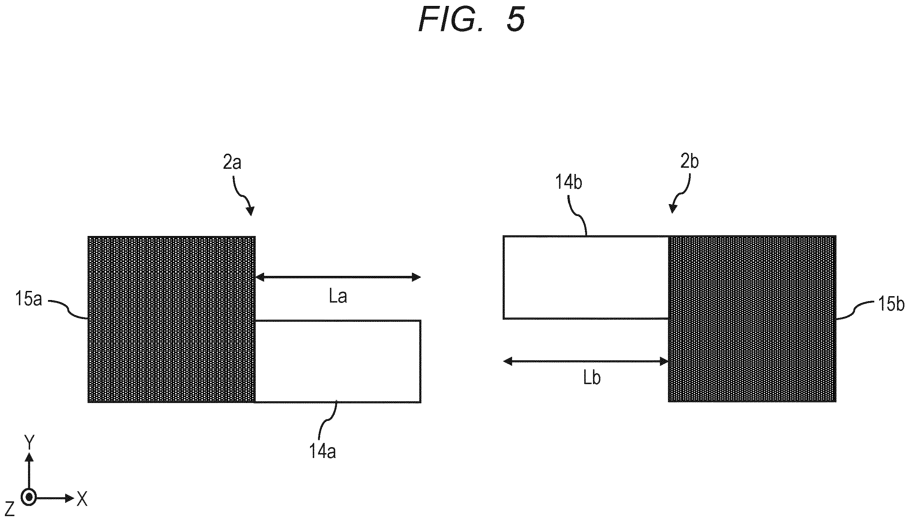

Here, an example of processing of arranging adjustment cells performed in the step S430 will be described. FIGS. 5 to 8 are plan views explaining an example of a method of arranging adjustment cells according to the first embodiment. Here, a method of arranging the adjustment cell 2a having the L-shaped boundary shape and the adjustment cell 2b having the inverted L-shaped boundary shape will be illustrated. First, as shown in FIG. 5, the paired adjustment cells 2a and 2b are extracted from the standard cells to be arranged on the semiconductor chip.

The adjustment cell 2a has regions 14a and 15a. The region 14a corresponds to a portion projecting in the +X axis direction, that is, the projection part of the adjustment cell 2a. The region 15a corresponds to a remaining portion of the adjustment cell 2a excluding the region 14a. Therefore, each of the regions 14a and 15a has a quadrangular boundary shape, and becomes a region obtained by dividing the adjustment cell 2a. The adjustment cell 2b also has regions 14b and 15b. The region 14b corresponds to a portion projecting in the -X axis direction, that is, the projection part of the adjustment cell 2b. The region 15b corresponds to a remaining portion of the adjustment cell 2b excluding the region 14b. Therefore, each of the regions 14b and 15b has a quadrangular boundary shape, and becomes a region obtained by dividing the adjustment cell 2b.

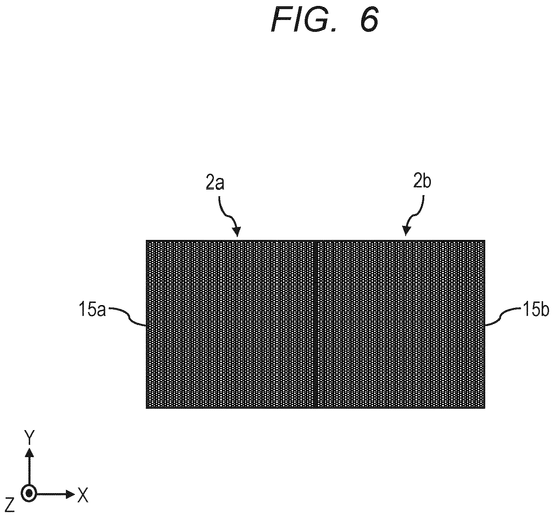

Next, as shown in FIG. 6, the adjustment cells 2a and 2b are arranged on the semiconductor integrated circuit such that the region 15a of the adjustment cell 2a and the region 15b of the adjustment cell 2b are adjacent to each other in the X axis direction. At this time, the region 14a of the adjustment cell 2a is arranged at a location overlapping with the region 15b of the adjustment cell 2b. Therefore, in FIG. 6, the region 14a is not displayed. Further, the region 14b of the adjustment cell 2b is arranged at a location overlapping with the region 15a of the adjustment cell 2a. Therefore, in FIG. 6, the region 14b is not displayed.

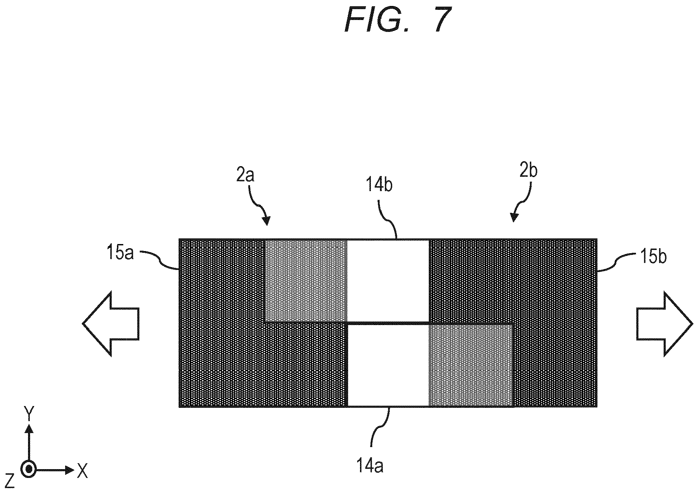

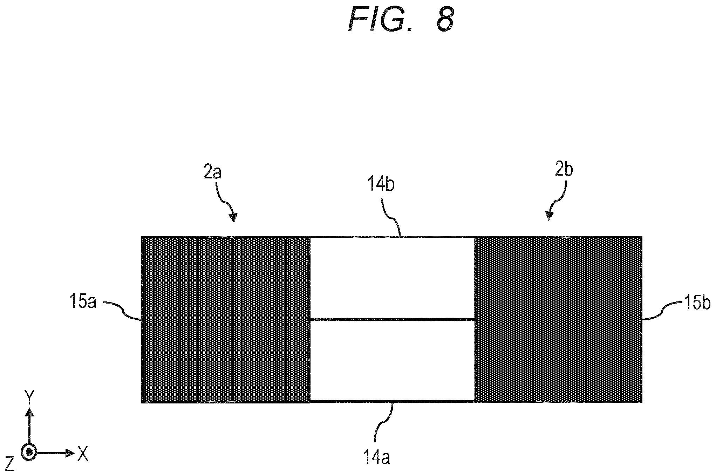

Next, as shown in FIG. 7, the adjustment cell 2a is moved in the -X axis direction, and the adjustment cell 2b is moved in the +X axis direction. The adjustment cells 2a and 2b are moved until there is no region overlapping each other. That is, the adjustment cell 2a is moved until the region 14a and the region 15b do not overlap with each other. Further, the adjustment cell 2b is moved until the region 14b and the region 15a do not overlap with each other. Then, as shown in FIG. 8, when the adjustment cell 2a and the adjustment cell 2b do not overlap with each other, the arrangement of the adjustment cells 2a and 2b on the semiconductor integrated circuit is determined.

Although the example of the method of arranging the adjustment cells has been described with reference to FIGS. 5 to 8, a method of arranging the adjustment cells is not limited to this. For example, after the adjustment cells 2a and 2b are arranged on the semiconductor integrated circuit in the state shown in FIG. 5, the adjustment cells 2a and 2b may be brought close to each other until they come into contact with each other.

In addition, it is preferable that a pair of adjustment cells to be extracted in the processing of arranging the adjustment cells have the same length of the projection part in the X axis direction. As shown in FIG. 5, if the length La of the projection part of the adjustment cell 2a is the same as the length Lb of the projection part of the adjustment cell 2b, the adjustment cell 2a and 2b can be arranged without a gap between the region 14a and the region 15b, or the region 15a and the region 14b.

Referring back to FIG. 4, the description of the design flow of the semiconductor integrated circuit using the adjustment cell according to the first embodiment will be continued. In the step S440, a mask pattern is created. The mask pattern is created based on the netlist and the placement information generated in the step S430. Incidentally, after the mask pattern is created, by transferring the mask pattern onto the semiconductor chip using the created mask pattern, a desired semiconductor integrated circuit is formed on the semiconductor chip.

Thus, according to the first embodiment, in designing a cell-based semiconductor integrated circuit, not only a standard cell having a quadrangular boundary shape but also standard cells having an L-shaped and an inverted L-shaped boundary shapes can be utilized. In particular, a standard cell (adjustment cell) having a boundary shape along a shape of a layout of a CMOS circuit having projection and recess parts generated by a difference between the number of P-channel MOS transistors and the number of N-channel MOS transistors does not include a region (dead space) where the transistor is not formed.

Adjustment cells that do not have a quadrangular boundary shape and do not include a dead space can be efficiently arranged on a semiconductor integrated circuit such that the projection parts and the recess parts of the boundary shapes are combined with each other. Therefore, as compared with the case where adjustment cells having a quadrangular boundary shape and including a dead space are combined, a semiconductor integrated circuit according to the first embodiment can reduce the area of the semiconductor chip and improve the integration rate of the transistor elements.

Further, in recent years, in order to reduce the chip area of a semiconductor integrated circuit, there is a tendency to shorten the length of the standard cell in the direction in which the gate electrode of the MOS transistor extends (for example, the Y axis direction in FIG. 1). As a means for adjusting the circuit characteristics of the semiconductor integrated circuit, a method of adjusting the gate length of the MOS transistor can be considered but adjusting the gate length of the MOS transistor is not suitable for such a recent tendency. Therefore, the adjustment cell tends to be a laterally elongated shape extending in a direction (e.g., the X axis direction in FIG. 1) perpendicular to the direction in which the gate electrode of the MOS transistor extends. The elongated adjustment cell is not only a major factor that hinders the reduction of the chip area and the improvement of the integration rate of the transistor elements, but also a factor that reduces the flexibility of the cell arrangement. However, these problems can be solved by using the adjustment cells according to the first embodiment.

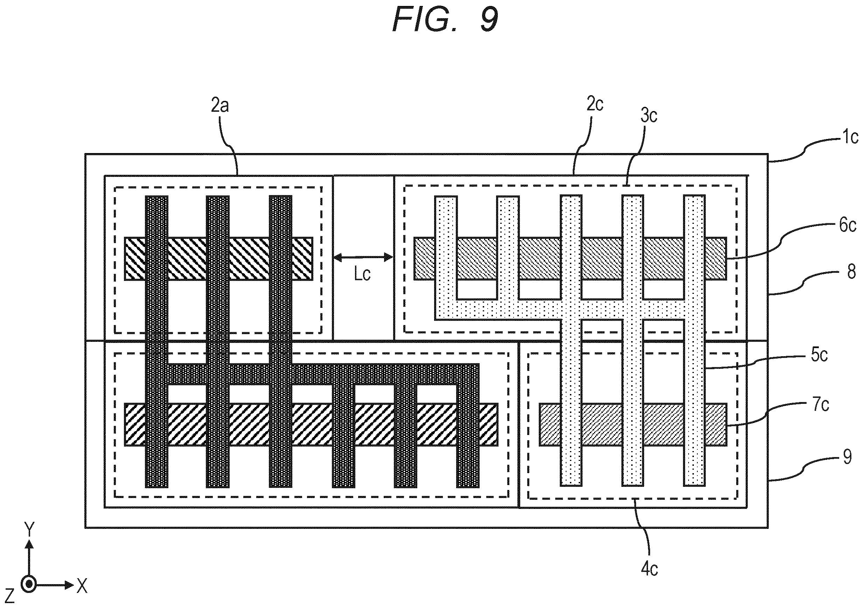

In the above-described first embodiment, as shown in FIG. 1, it has been explained that the adjustment cells 2a and 2b that are in a congruent figure relationship are arranged adjacent to each other without a gap. However, the two adjustment cells in the pair do not necessarily have to be in a congruent figure relationship, nor do they need to be arranged without a gap. FIG. 9 is a plan view showing an example of a layout of a semiconductor integrated circuit 1c according to the first embodiment. As shown in FIG. 9, adjustment cells 2a and 2c are arranged on the semiconductor integrated circuit 1c. The adjustment cell 2c has an inverted L-shaped hexagonal boundary shape, but the adjustment cells 2a and 2c are not in congruent figure relationship. Further, the adjustment cells 2a and 2c are not arranged adjacent to each other without a gap.

The adjustment cell 2c includes a P-channel MOS transistor forming region 3c, an N-channel MOS transistor region 4c, and a gate electrode 5c. The P-channel MOS transistor forming region 3c is formed by the N-type well 8. The N-channel MOS transistor forming region 4c is formed by the P-type well 9. The gate electrode 5c is arranged in the P-channel MOS transistor forming region 3c and the N-channel MOS transistor forming region 4c and acts as a common gate for P-channel MOS transistors and N-channel MOS transistors. P+ diffusion layers 6c are formed in the P-channel MOS transistor forming region 3c. The P+ diffusion layers 6c serve as sources and drains for the P-channel MOS transistors formed in the P-channel MOS transistor forming region 3c. N+ diffusion layers 7c are formed in the N-channel MOS transistor forming region 4c. The N+ diffusion layers 7c serve as sources and drains for the N-channel MOS transistors formed in the N-channel MOS transistor forming region 4c.

As shown in FIG. 9, the five gate electrodes 5c in the Y axis direction extend in the P-channel MOS transistor forming region 3c Therefore, five P-channel MOS transistors are formed in the P-channel MOS transistor forming region 3c. That is, since the number of P-channel MOS transistors included in the adjustment cell 2c is smaller than the number of N-channel MOS transistors included in the adjustment cell 2a, a portion projecting in the -X axis direction, that is, the projection part of the adjustment cell 2c is shorter than the portion projecting in the +X axis direction, that is, the projection part of the adjustment cell 2a.

On the other hand, the three gate electrodes extend in the Y axis direction in the N-channel MOS transistor forming region 4c, Therefore, three N-channel MOS transistors are formed in the N-channel MOS transistor region 4c. That is, the size of the region of the N-type well 9 of the adjustment cell 2c is the same as the size of the region of the P-type well 9 of the adjustment cell 2a.

Comparing the boundary shapes of the adjustment cell 2a and the adjustment cell 2c, the projection part of the adjustment cell 2c is shorter than the projection part of the adjustment cell 2a. Therefore, when the adjustment cells 2a and 2c are arranged on the semiconductor integrated circuit 1c such that the projection parts and the recess parts of the boundary shapes of the adjustment cells 2a and 2c are combined with each other, as shown in FIG. 9, there is a gap of length Lc in the X-axis direction between the adjustment cell 2a and the adjustment cell 2c in the N-type well 8 side of the semiconductor integrated circuit 1c. Although the semiconductor integrated circuit 1c is a layout including such a gap, the chip area of the semiconductor integrated circuit 1c is smaller than the chip area of the semiconductor integrated circuit 10 of FIG. 2.

Thus, in the first embodiment, an adjustment cell having an L-shaped boundary shape and an adjustment cell having an inverted L-shaped boundary shape are arranged adjacent to each other along the X axis direction and are arranged such that each adjustment cell has a region overlapping with each other in the Y axis direction. In other words, the adjustment cell having the L-shaped boundary shape and the adjustment cell having the inverted L-shaped boundary shape are arranged adjacent to each other along the X axis direction such that the projection part of the adjustment cell having the L-shaped boundary shape and the projection part the adjustment cell having the inverted L-shaped boundary shape overlap in Y axis direction. Then, at this time, all of the projection part of the adjustment cell having the L-shaped boundary shape need not overlap with all of the projection part of the adjustment cell having the inverted L-shaped boundary shape.

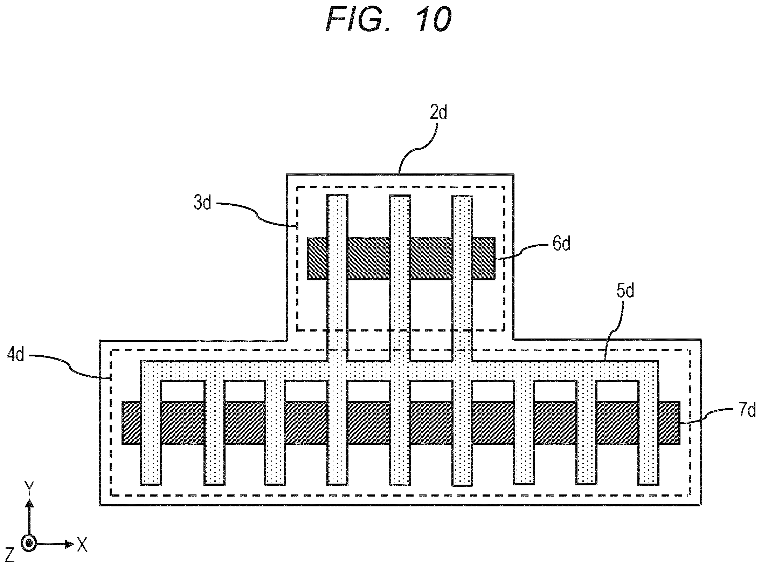

Further, in the above-described first embodiment, the adjustment cells having the L-shaped boundary shape and the inverted L-shaped boundary shape are exemplified, but the boundary shape of the adjustment cell according to the first embodiment is not limited to these. For example, an adjustment cell may have a boundary shape corresponding to a figure obtained by linearly symmetrically moving the adjustment cell 2a of FIG. 1 with respect to the X axis as the target axis. In addition, an adjustment cell may have a convex-shaped boundary shape or an inverted convex-shaped boundary shape. FIG. 10 is a plan view showing a layout of an adjustment cell 2d according to the first embodiment. As shown in FIG. 10, the boundary shape of the adjustment cell 2d is a convex-shaped octagon having eight sides.

Adjustment cell 2d includes a P-channel MOS transistor region 3d and an N-channel MOS transistor region 4d. A common gate electrode 5d is arranged in the P-channel MOS transistor region 3d and the N-channel MOS transistor region 4d, P+ diffusion layers 6d are formed in the P-channel MOS transistor forming region 3d, N + diffusion layers 7d are formed in the N-channel MOS transistor forming region 4d.

In the P-channel MOS transistor region 3d, since the three gate electrodes 5d in the Y axis direction extend, three P-channel MOS transistors are formed. On the other hand, in the N-channel MOS transistor region 4d, since the nine gate electrodes 5d in the Y axis direction extend, nine N-channel MOS transistors are formed. Thus, the adjustment cell 2d includes a layout of a CMOS circuit of a convex-shaped generated by a difference between the number of P-channel MOS transistors and the number of N-channel MOS transistors. Then, the boundary shape of the adjustment cell 2d becomes a convex octagon along the layout of the CMOS circuit of the convex-shaped. Thus, a dead space as shown in FIG. 2 is not formed in the adjustment cell 2d.

As shown in FIG. 10, the adjustment cell 2d becomes a convex-shaped boundary shape having a projection part in the +X axis direction and a projection part in the -X axis direction. When the adjustment cell 2d having the convex-shaped boundary shape is arranged on the semiconductor integrated circuit, it is preferable that the adjustment cell 2b having the inverted L-shaped boundary shape is arranged on the +X axis direction side of the adjustment cell 2d and an adjustment cell having a boundary shape corresponding to a figure obtained by linearly symmetrically moving the adjustment cell 2a having the L-shaped boundary shape with respect to the X axis as the target axis is arranged on the -X axis direction side of the adjustment cell 2d. In other words, it is preferable that the adjustment cell 2b having the inverted L-shaped boundary shape and the adjustment cell 2d having the convex-shaped boundary shape are arranged such that each of these adjustment cells has a region overlapping with each other in the Y axis direction, and an adjustment cell having a boundary shape corresponding to a figure obtained by linearly symmetrically moving the adjustment cell 2a having the L-shaped boundary shape with respect to the X axis as the target axis and the adjustment cell 2d having the convex-shaped boundary shape are arranged such that each of these adjustment cells has a region overlapping with each other in the Y axis direction. Thus, it is possible to efficiently arrange the three adjustment cells including the adjustment cell 2d on the semiconductor integrated circuit.

As described above, the boundary shape of the adjustment cell according to the first embodiment may be various polygonal shapes excluding a quadrangle, for example, an L-shaped hexagon, an inverted L-shaped hexagon, and a convex-shaped octagon. That is, the boundary shape of the adjustment cell according to the first embodiment may be a polygon with n (where, n is a natural number of >4) sides. At this time, it is more preferable that n is an even number, that is, the boundary shape of the adjustment cell is a polygon with an even number of sides. If the number of sides is even, all sides of the boundary shape of the adjustment cell becomes parallel to the X axis or the Y axis, and as a result, the degree of freedom in cell arrangement is increased.

Further, in the above-described first embodiment, the basic logic cell constituting the CMOS inverter as an adjustment cell is exemplified, the basic logic cell is not limited to the inverter. For example, an AND circuit, an OR circuit, or the like may be used.

In the above-described first embodiment, the boundary shape of the adjustment cell 2a is represented as an L-shaped, and the boundary shape of the adjustment cell 2b is represented as an inverted L-shaped. However, the boundary shapes of the adjustment cells 2a and 2b may be represented as an L-shaped collectively. That is, in the present specification, the boundary shape of the adjustment cell, which has a congruent figure relationship with the boundary shape of the adjustment cell 2a, can also be collectively referred to as an L-shaped.

### Second Embodiment

Next, a second embodiment will be described. Even when the standard cells are arranged by successfully combining adjustment cells having L-shaped or convex-shaped boundary shapes, it is also conceivable that a gap is generated between the standard cells. In the second embodiment, a standard cell suitable for filling such a gap will be described.

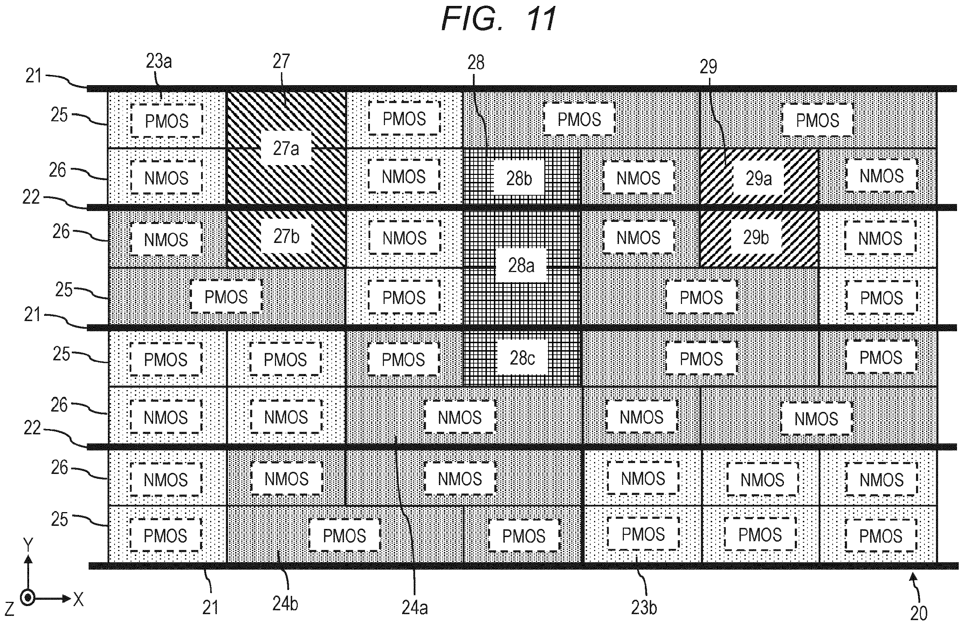

FIG. 11 is a plan view showing an example of a layout of a semiconductor integrated circuit 20 according to the second embodiment. In FIG. 11, only a part of the semiconductor integrated circuit 20 is shown. As shown in FIG. 11, the semiconductor integrated circuit 20 includes a first power supply wiring 21 for supplying a first power supply potential, a second power supply wiring 22 for supplying a second power supply potential, and standard cells 23a, 23b, 24a and 24b. The first power supply potential is higher than the second power supply potential. Each of the standard cells 23a and 23b has a quadrangular boundary shape. Each of the standard cells (adjustment cells) 24a and 24b has an L-shaped boundary shape.

The standard cell 23a has an N-type well 25 on the +Y axis direction side and a P-type well 26 on the -Y axis direction side. The standard cells 23b has the P-type well 26 on the +Y axis direction side and the N-type well 25 on the -Y axis direction side. The standard cell 24a has the N-type well 25 on the recess part side and the P-type well 26 on the projection part side. The standard cell 24b has the P-type well 26 on the recess part side and the N-type well 25 on the projection part side. P-channel MOS transistors are formed on the N-type wells 25 of the standard cells 23a, 23b, 24a and 24b. N-channel MOS transistors are formed on the P-type wells 26 of the standard cells 23a, 23b, 24a and 24b. The N-type well 25 and the P-type well 26 in the standard cells 23a, 23b, 24a and 24b are arranged adjacent to each other in the Y axis direction. In FIG. 11, all of the standard cells having a figure relationship congruent with the standard cell 24a, having the N-type well 25 on the recess part side and having the P-type well 26 on the projection part side are treated as the standard cells 24a. Further, all of the standard cells having a figure relationship congruent with the standard cell 24b, having the P-type well 26 on the recess part side and having the N-type well 25 on the projection part side are treated as the standard cells 24b.

As shown in FIG. 11, a plurality of standard cells 23a, 23b, 24a and 24b is arranged on the semiconductor integrated circuit 20, Specifically, the standard cells 24a and 24b having the L-shaped boundary shape are arranged adjacent to each other along the X axis direction and are arranged such that each of the standard cells 24a and 24b has a region overlapping with each other in the Y axis direction. Further, the standard cells 24a and 24b arranged in this manner are arranged adjacent to the other standard cells 23a, 23b, 24a or 24b. At this time, each of the adjacent standard cells does not have a region overlapping with each other in the X axis direction and the Y axis direction.

The first power supply wiring 21 is formed above the N-type well 25, and the second power supply wiring is formed above the P-type well 26. Further, as shown in FIG. 11, the first power supply wiring 21 extends in the X axis direction, and a part of the first power supply wiring 21 is arranged at the cell boundary on the side where the N-type well 25 of the standard cell 23a, 23b, 24a, or 24b is located. The second power supply wiring 22 extends in the X axis direction in parallel with the first power supply wiring 21, and a part of the second power supply wiring 22 is arranged at the cell boundary on the side where the P-type well 26 of the standard cell 23a, 23b, 14a, or 24b is located. Thus, standard cells 23a, 23b, 24a and 24b are arranged between the first power supply wiring 21 and the second power supply wiring 22. Further, the first power supply wiring 21 is arranged at a location sandwiched by two of the N-type wells 25 of the standard cells 23a, 23b, 24a, and 24b, and the second power supply wiring 22 is arranged at a location sandwiched by two of the P-type wells 26 of the standard cells 23a, 23b, 24a, and 24b.

The semiconductor integrated circuit 20 also includes regions 27, 28 and 29. The regions 27, 28 and 29 are regions in which none of standard cells 23a, 23b, 24a and 24b are located. That is, the regions 27, 28 and 29 are gaps that generated between the standard cells when a plurality of standard cells is arranged on the semiconductor integrated circuit 20.

The region 27 is a quadrangular region and has a size 1.5 times larger than that of the standard cell 23a or 23b. As shown in FIG. 11, the region 27 includes a region 27a corresponding to the standard cell 23a and a region 27b located on the -Y axis direction side of the region 27a. The region 27b corresponds to half the size of the standard cell 23a. Since the region 27b is a region adjacent to the second power supply wiring 22, it is a region where the P-type well 26 where N-channel MOS transistor is formed is to be arranged. Here, if the standard cell 23a is arranged in the region 27a, the region 27b is left behind. That is, the standard cell 23a cannot be used to fill the entire region 27 without a gap.

The region 28 is a quadrangular region and has twice the size of the standard cell 23a or 23b. As shown in FIG. 11, the region 28 includes a region 28a corresponding to the standard cell 23b, a region 28b located on the +Y axis direction side of the region 28a, and the region 28c located on the -Y axis direction side of the region 28a. Each of the regions 28b and 28c corresponds to half the size of the standard cell 23b. Since the region 28b is a region adjacent to the second power supply wiring 22, it is a region where the P-type well 26 where N-channel MOS transistor is formed is to be arranged. Further, since the region 28c is a region adjacent to the first power supply wiring 21, it is a region where the N-type well 25 where P-channel MOS transistor is formed is to be arranged. Here, if the standard cell 23b is arranged in the region 28a, the regions 28b and 28c are left behind. That is, the standard cell 23b cannot be used to fill the entire region 28 without a gap.

The region 29 is a quadrangular region and has the same size as the standard cell 23a or 23b. As shown in FIG. 11, the region 29 includes regions 29a and 29b located across the second power supply wiring 22. Since the regions 29a and 29b are regions adjacent to the second power supply wiring 22, they are regions where the P-type wells 26 where N-channel MOS transistor is formed is to be arranged. That is, since there is no region forming P-channel MOS transistor in the region 29, it is impossible to arrange the standard cell 23a or 23b having the P-channel MOS transistor and the N-channel MOS transistor. Therefore, the standard cell 23a or 23b cannot be used to fill the region 29.

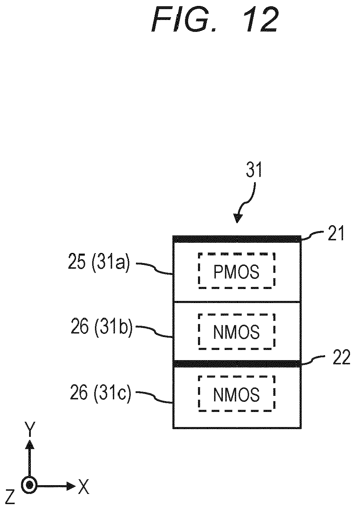

FIGS. 12 to 14 are plan views showing examples of layouts of standard cells 31, 32 and 33 according to the second embodiment. FIG. 12 shows the standard cell 31 suitable for filling the region 27. As shown in FIG. 12, the standard cell 31 has a quadrangular boundary shape and includes three regions 31a, 31b, and 31c formed by the N-type well 25 and the P-type well 26. The region 31a is formed by the N-type well 25 and is a region where P-channel MOS transistor is formed. The regions 31b and 31c are formed by the P-type well 26 and are regions where N-channel MOS transistors are formed. The regions 31a, 31b, and 31c are arranged in the order of the region 31a, the region 31b, and the region 31c in the -Y axis direction. The first power supply wiring 21 is arranged at the cell boundary of the +Y axis direction side of the standard cell 31. The second power supply wiring 22 is arranged between the region 31b and the region 31c. That is, in the plan view of FIG. 12, the second power supply line 22 is not arranged at the cell boundary of the standard cell 31 but is arranged inside the standard cell 31.

As shown in FIG. 12, a region obtained by combining the regions 31a and 31b corresponds to the standard cell 23a. Further, the region 31c corresponds to a region of the P-type well 26 in the standard cell 23a. Therefore, the standard cell 31 is a standard cell in which the standard cell 23a is extended in the -Y axis direction by half the size of the standard cell 23a. In addition, the size of the N-type well 25 included in the standard cell 31 is smaller than the size of the P-type well 26 included in the standard cell 31. By using such a standard cell 31, it is possible to fill the region 27 of the semiconductor integrated circuit 20 without a gap.

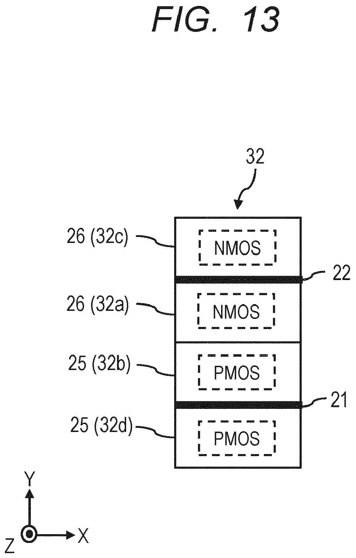

FIG. 13 shows the standard cell 32 suitable for filling the region 28. As shown in FIG. 13, the standard cell 32 has a quadrangular boundary shape and includes four regions 32a, 32b, 32c and 32d formed by the N-type well 25 and the P-type well 26. The regions 32a and 32c are formed by the P-type well 26 and are regions where N-channel MOS transistors are formed. The regions 32b and 32d are formed by the N-type well 25 and are regions where P-channel MOS transistors are formed. The regions 32a, 32b, 32c, and 32d are arranged in the order of the region 32c, the region 32a, the region 32b, and the region 32d in the -Y axis direction. The second power supply wiring 22 is arranged between the region 32a and the region 32c. The first power supply wiring 22 is arranged between the region 32b and the region 32d. That is, in the plan view of FIG. 13, the first power supply line 21 and the second power supply line 22 are not arranged at the cell boundary of the standard cell 32 but are arranged inside the standard cell 32.

As shown in FIG. 13, a region obtained by combining the regions 32a and 32b correspond to the standard cell 23b. Further, the region 32c corresponds to a region of the P-type well 26 in the standard cell 23b. The region 32d corresponds to a region of the N-type well 25 in the standard cell 23b. Therefore, the standard cell 32 is a standard cell in which the standard cell 23b is extended in the +Y axis direction by half the size of the standard cell 23b and is extended in the +Y axis direction by half the size of the standard cell 23b. The size of the N-type well 25 included in the standard cell 32 is the same as the size of the P-type well 26 included in the standard cell 32. By using such a standard cell 32, it is possible to fill the region 28 of the semiconductor integrated circuit 20 without a gap.

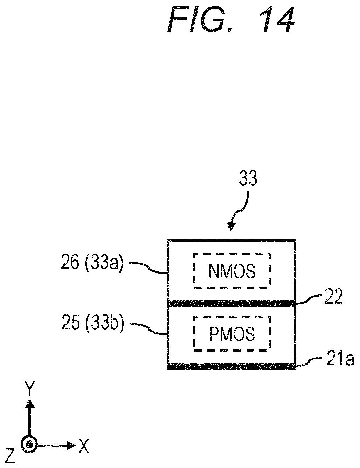

FIG. 14 shows the standard cell 33 suitable for filling the region 29. As shown in FIG. 14, the standard cell 33 has a quadrangular boundary shape and includes two regions 33a and 33b formed by the N-type well 25 and the P-type well 26. The region 33a is formed by the P-type well 26 and is a region where N-channel MOS transistor is formed. The region 33b is formed by the N-type well 25 and is a region where P-channel MOS transistor is formed. The regions 33a and 33b are arranged in the order of the region 33a and the region 31b in the -Y axis direction. The second power supply wiring 22 is arranged between the region 33a and the region 33b. That is, in the plan view of FIG. 14, the second power supply line 22 is not arranged at the cell boundary of the standard cell 33 but is arranged inside the standard cell 33. Further, a third power supply wiring 21a for supplying the first power supply potential is formed above of the N-type well 25. The third power supply wiring 21a extends in the X axis direction and is arranged at the cell boundary of the -Y axis direction side of the standard cell 33.

As shown in FIG. 14, a region obtained by combining the regions 33a and 33b corresponds to the standard cell 23a. The P-channel MOS transistor formed in the region 33b can be supplied with the first power supply potential from the third power supply wiring 21a. By using such a standard cell 33, it is possible to fill the region 29 of the semiconductor integrated circuit 20 without a gap.

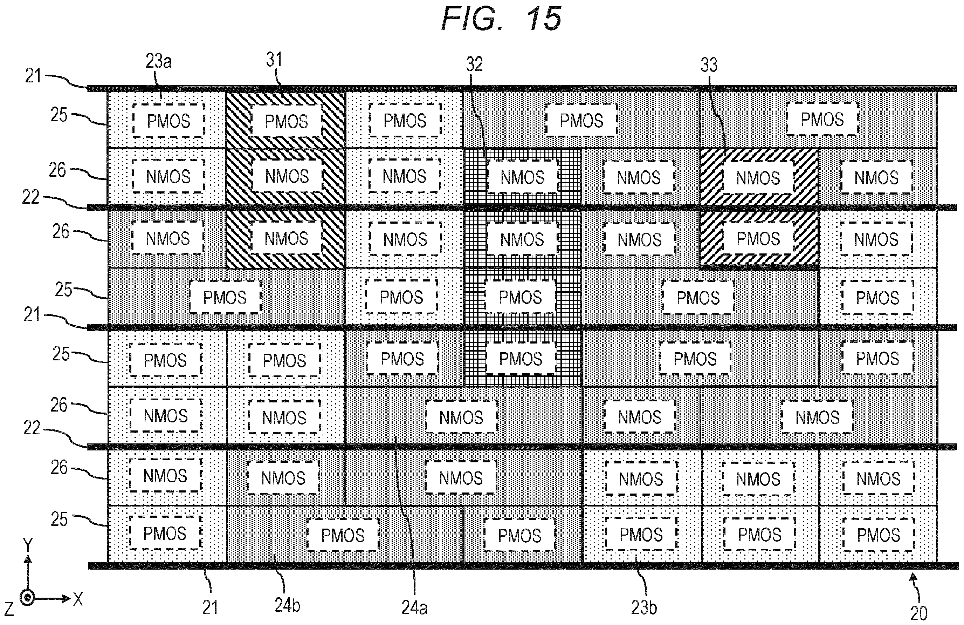

FIG. 15 is a plan view showing an example of a layout of the semiconductor integrated circuit 20 in which the standard cells 31, 32, and 33 are arranged according to the second embodiment. As shown in FIG. 15, the standard cell 31 is arranged in the region 27. The standard cell 31 is arranged such that the P-type well 26 forming the region 33b of the standard cell 31 and the P-type well 26 of the standard cell 24b adjacent thereto overlap in the X axis direction.

Further, as shown in FIG. 15, the standard cell 32 is arranged in the region 28. The standard cell 32 is arranged such that the P-type well 26 forming the region 32c of the standard cell 32 and the P-type well 26 of the standard cell 24b adjacent thereto overlap in the X axis direction. In addition, the standard cell 32 is arranged such that the N-type well 25 forming the region 32d of the standard cell 32 and the N-type well 25 of the standard cell 24a adjacent thereto overlap in the X axis direction.

Further, as shown in FIG. 15, the standard cells 33 is arranged in the region 29. The standard cell 33 is arranged such that the P-type well 26 forming the region 33a of the standard cell 33 and the P-type well 26 of the standard cell 24b adjacent thereto overlap in the X axis direction. In addition, the standard cell 33 is arranged such that the N-type well 25 forming the region 33b of the standard cell 33 and the P-type well 26 of the standard cell 24b adjacent thereto overlap in the X axis direction.

Since the region 33b of the standard cell 33 is originally a region in which the P-type well 26 is to be arranged, the type of the well of the standard cell adjacent to the region 33b in the X axis direction is different from the type of the well of the region 33b of the standard cell 33. Further, although the first power supply wiring 21 for supplying the first power supply potential is not originally arranged near the region 33b of the standard cell 33, the third power supply wiring 21a for supplying the first power supply potential is newly provided near the region 33b of the standard cell 33. Therefore, by utilizing the third power supply wiring 21a, it is possible to supply the first power supply potential to the P-channel MOS transistor formed in the region 33b.

As described above, according to the second embodiment, the standard cells 31, 32, and 33 can be used to arrange the standard cells on the semiconductor integrated circuit without a gap, it is possible to reduce the chip area of the semiconductor integrated circuit and improve the integration rate of the transistor elements.

Incidentally, in FIG. 12, it has been explained that the standard cell 31 is a standard cell in which the standard cell 23a is extended in the -Y direction by half the size of the standard cell 23a. However, the standard cell 31 is not limited to this and can be changed depending on the size and location of the gap generated between the standard cells. For example, the standard cell 31 may be a standard cell in which the standard cell 23a is extended in the +Y axis direction by half the size of the standard cell 23a. Further, the standard cell 31 may be extended in the +Y axis direction by the size of the standard cell 23a. Furthermore, the configuration of the wells in the standard cell 31 may be changed. For example, the region 31a may be formed by the P-type wells 26 and the regions 31b and 31c may be formed by the N-type well 25. The same applies to the standard cell 32 of FIG. 13 and the standard cell 33 of FIG. 14.

Although the invention made by the present inventor has been specifically described based on the embodiments, it is needless to say that the present invention is not limited to the above-described embodiments, and various changes may be made without departing from the scope thereof.

## Claims

1. A semiconductor integrated circuit comprising:
a first semiconductor layer which has a first conductivity type;
a second semiconductor layer which has a second conductivity type; and
a first cell and a second cell which are arranged adjacent to each other along a first direction,
wherein each of the first cell and the second cell has a polygonal boundary shape with n (where, n is a natural number of >4) sides,
wherein the first cell comprises:
a plurality of first Metal-Oxide-Semiconductor (MOS) transistors which are formed on the second semiconductor layer and which have the first conductivity type; and
a plurality of second MOS transistors which are formed on the first semiconductor layer and which have the second conductivity type,
wherein the second cell comprises:
a plurality of third MOS transistors which are formed on the second semiconductor layer and which have the first conductivity type; and
a plurality of fourth MOS transistors which are formed on the first semiconductor layer and which have the second conductivity type,
wherein the first cell and the second cell are arranged such that each of the first cell and the second cell has a region overlapping with each other in a second direction different from the first direction.

2. The semiconductor integrated circuit according to Claim 1,
wherein a number of first MOS transistors is less than a number of second MOS transistors, and
wherein a number of third MOS transistors is greater than a number of fourth MOS transistors.

3. The semiconductor integrated circuit according to Claim 1 or 2, wherein the second direction is a direction perpendicular to the first direction.

4. The semiconductor integrated circuit according to Claim 1,
wherein the first cell is a basic logic cell which comprises a Complementary MOS (CMOS) circuit in which a number of first MOS transistors and a number of second MOS transistors are different, and
wherein the second cell is a basic logic cell which comprises a CMOS circuit in which a number of third MOS transistors and a number of fourth MOS transistors are different.

5. The semiconductor integrated circuit according to any one of Claims 1 to 4, further comprising:
a first power supply wiring which is formed above the second semiconductor layer and which supplies a first power supply potential; and
a second power supply wiring which is formed above the first semiconductor layer and which supplies a second power supply potential,
wherein each of the first power supply wiring and the second power supply wiring is arranged parallel to the first direction,
wherein a part of the first power supply wiring is arranged at a first cell boundary of the first cell or the second cell,
wherein the first cell boundary is a cell boundary on a side where the second semiconductor layer of the first cell or the second cell is located,
wherein a part of the second power supply wiring is arranged at a second cell boundary of the first cell or the second cell, and
wherein the second cell boundary is a cell boundary on a side where the first semiconductor layer of the first cell or the second cell is located.

6. The semiconductor integrated circuit according to any one of Claims 1 to 5, wherein all sides of the first cell and the second cell are parallel to the first direction or the second direction.

7. The semiconductor integrated circuit according to Claim 6, wherein each of the first cell and the second cell has a hexagonal boundary shape with six sides.

8. The semiconductor integrated circuit according to Claim 7, wherein each of the first cell and the second cell has a boundary shape which is congruent to each other.

9. The semiconductor integrated circuit according to Claim 7 or 8, further comprising a third cell which is arranged adjacent to the second cell along the first direction and which has a quadrangular boundary shape with four sides,
wherein the third cell comprises:
a plurality of fifth MOS transistors which are formed on the second semiconductor layer and which have the first conductivity type; and
a plurality of sixth MOS transistors which are formed on the first semiconductor layer and which have the second conductivity type,
wherein the second cell is arranged between the first cell and the third cell in the first direction, and
wherein the second cell and the third cell are arranged such that each of the second cell and the third cell does not have a region overlapping with each other in the second direction.

10. The semiconductor integrated circuit according to Claim 7, further comprising a fourth cell which is arranged adjacent to the first cell or the second cell along the second direction and which has a quadrangular boundary shape with four sides, and
wherein the fourth cell comprises:
a plurality of seventh MOS transistors which are formed on the second semiconductor layer and which have the first conductivity type; and
a plurality of eighth MOS transistors which are formed on the first semiconductor layer and which have the second conductivity type.

11. The semiconductor integrated circuit according to Claim 6,
wherein the first cell has a hexagonal boundary shape with six sides, and
wherein the second cell has an octagonal boundary shape with eight sides.

12. The semiconductor integrated circuit according to Claim 11, further comprising a fifth cell which is arranged adjacent to the second cell along the first direction and which has a hexagonal boundary shape with six sides,
wherein the fifth cell comprises:
a plurality of ninth MOS transistors which are formed on the second semiconductor layer and which have the first conductivity type; and
a plurality of tenth MOS transistors which are formed on the first semiconductor layer and which have the second conductivity type,
wherein the second cell is arranged between the first cell and the fifth cell in the first direction, and
wherein the second cell and the fifth cell are arranged such that each of the second cell and the fifth cell has a region overlapping with each other in the second direction.

13. The semiconductor integrated circuit according to Claim 1, further comprising:
a sixth cell which has a hexagonal boundary shape with six sides;
a first power supply wiring which is formed above the second semiconductor layer and which supplies a first power supply potential; and
a second power supply wiring which is formed above the first semiconductor layer and which supplies a second power supply potential,
wherein each of the first power supply wiring and the second power supply wiring is arranged parallel to the first direction,
wherein the sixth cell comprises:
a plurality of eleventh MOS transistors which are formed on the second semiconductor layer and which have the first conductivity type; and
a plurality of twelfth MOS transistors which are formed on the first semiconductor layer and which have the second conductivity type,
wherein a part of the first power supply wiring is arranged at a first cell boundary of the sixth cell,
wherein the first cell boundary is a cell boundary on a side where the second semiconductor layer of the sixth cell is located,
wherein a part of the second power supply wiring is arranged at a second cell boundary of the sixth cell, and
wherein the second cell boundary is a cell boundary on a side where the first semiconductor layer of the sixth cell is located.

14. The semiconductor integrated circuit according to Claim 13, further comprising a seventh cell which is arranged adjacent to the sixth cell along the second direction and which has a quadrangular boundary shape with four sides,
wherein the seventh cell comprises:
a plurality of thirteenth MOS transistors which are formed on the second semiconductor layer and which have the first conductivity type; and
a plurality of fourteenth MOS transistors which are formed on the first semiconductor layer and which have the second conductivity type, and
wherein the sixth cell and the seventh cell are arranged such that the second semiconductor layer of the sixth cell and a part of the second semiconductor layer of the seventh cell overlap in the first direction.

15. The semiconductor integrated circuit according to Claim 14, wherein a size of the first semiconductor layer included in the seventh cell is smaller than a size of the second semiconductor layer included in the seventh cell.

16. The semiconductor integrated circuit according to Claim 14, wherein a size of the first semiconductor layer included in the seventh cell is equal to a size of the second semiconductor layer included in the seventh cell.

17. The semiconductor integrated circuit according to Claim 13, further comprising an eighth cell which is arranged adjacent to the sixth cell along the second direction and which has a quadrangular boundary shape with four sides,
wherein the eighth cell comprises:
a plurality of fifteenth MOS transistors which are formed on the second semiconductor layer and which have the first conductivity type; and
a plurality of sixteenth MOS transistors which are formed on the first semiconductor layer and which have the second conductivity type, and
wherein the sixth cell and the eighth cell are arranged such that the second semiconductor layer of the sixth cell and a part of the first semiconductor layer of the eighth cell overlap in the first direction.

18. The semiconductor integrated circuit according to Claim 17, further comprising a third power supply wiring which is formed above the first semiconductor layer and which supplies the first power supply potential,
wherein the third power supply wiring is arranged parallel to the first direction and is arranged at a third cell boundary of the eighth cell, and
wherein the third cell boundary is a cell boundary on a side where the first semiconductor layer of the eighth cell is located.
